# EUROPEAN PATENT SPECIFICATION

(11) **EP 3 703 108 B1**
(45) Date of publication and mention of the grant of the patent: **06.05.2026**
(21) Application number: 20461511.6
(22) Date of filing: 25.02.2020
(51) Int. Cl.: H10P 14/26, H10P 14/20

(54) **HYDROTHERMAL METHOD OF PRODUCING A CUO LAYER ON A SUBSTRATE**
HYDROTHERMALES VERFAHREN ZUR HERSTELLUNG EINER CUO-SCHICHT AUF EINEM SUBSTRAT
MÉTHODE HYDROTHERMALE DE PRODUCTION D'UNE COUCHE DE CUO SUR UN SUBSTRAT

(30) Priority: 26.02.2019 PL 42906619
(43) Date of publication of application: 02.09.2020
(73) Proprietor: Instytut Fizyki Polskiej Akademii Nauk, 02-668 Warszawa (PL)
(72) Inventor: Godlewski, Marek, 03-543 Warszawa (PL); Ozga, Monika, 03-978 Warszawa (PL); Witkowski, Bartlomiej, 03-138 Warszawa (PL)
(74) Representative: Witek, Rafal

(56) References cited:
- PL-B1- 225 326
- US-A1- 2016 005 599
- IBUPOTO Z H ET AL: "Low temperature synthesis of seed mediated CuO bundle of nanowires, their structural characterisation and cholesterol detection", MATERIALS SCIENCE AND ENGINEERING C, vol. 33, no. 7, 18 May 2013 (2013-05-18), pages 3889 - 3898, XP028686198, ISSN: 0928-4931, DOI: 10.1016/J.MSEC.2013.05.029

## Description

The present invention relates to a hydrothermal method for preparing a CuO layer on a substrate. CuO layers are widely used in photovoltaic cells, sensors and in optoelectronic devices.

Various methods for preparing CuO layers and nanostructures are described in the literature. A group of methods that allow relatively good control of physical parameters are methods used for semiconductor growth, e.g. CVD (Chemical Vapor Deposition), PLD (Pulsed Layer Deposition).

The description of the method of growth of CuO layers by the PLD method is known from the publication entitled "Controlled growth and characteristics of single-phase Cu2O and CuO films by pulsed laser deposition", A. Chen, H. Long, X. Li, Y. Li, G. Yang, P. Lu, Vacuum, vol 83 (6), 2009, pp. 927-930, 10.1016/j.vacuum.2008.10.103. However, due to relatively expensive technology and the lack of easy process control, this method is not suitable for industrial applications.

The review work "CuO nanostructures: Synthesis, characterization, growth mechanisms, fundamental properties, and applications", Q, Zhang, K. Zhang, D. Xu, G. Yang, H. Huang, F. Nie, C. Liu, S. Yang, Progress in Materials Science, vol. 60, 2014, pp. 208-337, 10.1016/j.pmatsci.2013.09.003 describes many ways to grow nanostructures from a solution. Based on the growth methods described there, nanostructures of various shapes and sizes and with a more or less developed surface are prepared. Obtained copper oxide nanostructures take various forms, but this work does not present a method for the growth of homogeneous CuO layers, which are crucial for many applications.

The publication: "Study on structure and optical properties of CuO thin films prepared by chemical spray pyrolysis", A. N. Hussein, S. K. Muhammad, S. A. Mohsin and F. N. Ajeel, Journal of Applied Physical Science International, 4 (3): 178-184, 2015, presents the method of growth of the CuO layer by spray pyrolysis.

In this method, copper acetate solution was applied by spraying onto substrates at various temperatures (from 300 °C to 500 °C).

These growth temperatures, unfortunately, exclude the possibility of using some substrates, e.g. glass or plastic.

A method for preparing a CuO layer on a glass substrate is known from the publication entitled "The preparation of copper (II) oxide thin films and the study of their microstructures and optical properties" A. Y. Oral, E. Men 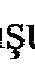 ur, M. H. Aslan, E. Ba 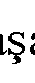 aran, Materials Chemistry and Physics, vol. 83 (1), 2004, pp. 140-144, 10.1016/j.matchemphys.2003.09.015. In this method, copper acetate was first dissolved in isopropanol and diethanolamine, then polyethylene glycol (PEG, H(OCH₂CH₂)ₙOH) and water were added. Subsequently, the resulting solution was repeatedly spread on glass using the "spin-coating" method. Then the glass was heated to 250 °C and this temperature was maintained for 5 minutes, then it was transferred to an oven heated to 300 °C and the temperature was raised to 600 °C. The temperature was maintained at 600 °C for 30 minutes. The described method resulted in a 800 nm thick CuO layer on a glass substrate. The process required the use of special glass that was able to withstand a temperature of 600 °C. Quite complicated process chemistry, the use of spin-coating and multi-stage soaking cause that the presented method is not very attractive for industrial applications. Further modifications of this method can be found in the literature, but in technological matters they do not differ from the method described above.

The object of the invention is to develop a cheap, simple and fast method for preparing a CuO layer on a substrate. A method that would guarantee uniform thickness and electrical properties of the layer, and easy scaling of the method to large substrate sizes.

The method for preparing a CuO layer on a substrate according to the invention is defined in claim 1. Preferably, the amount of Au, Ag, Cu nanostructures on the surface of the substrate is greater than 100/µm². Preferably, the copper precursor is copper acetate or copper nitrate.

The hydrothermal method for preparing a CuO layer on the substrate is very simple, it does not require the use of complicated apparatus for controlling gas or liquid flow or maintaining a high vacuum. It is a safe process because the growth occurs at a relatively low temperature (approx. 60-100 °C) and at atmospheric pressure. Preparation of the reaction mixture only requires mixing the precursors in water or other solvent.

The invention will be explained in more detail in three embodiments.

In the first example, the preparation of the CuO layer is carried out on a silicon substrate. The method according to the invention uses a mechanism of growth nucleation through metallic nanostructures, in this example gold nanostructures. The example method consists of two steps. The first step is the appropriate preparation of the substrate. In the example method, a 0.5 mm thick silicon wafer was used as the substrate. A thin (approx. 0.4 nm) layer of gold (wherein the metal/gold layer can be much thicker) was sprayed onto the surface of this substrate by cathodic sputtering. In a second step, a reaction mixture with a pH of 6.5 is prepared. For this purpose, 1.5 g of copper acetate was dissolved in 150 ml of distilled water (which acts as a solvent and oxygen precursor). The appropriate pH of the mixture was obtained after thorough mixing by precipitation of metal hydroxide which is sodium hydroxide. In the mixture prepared in this way, the substrate prepared in the first stage was placed with gold balls formed on the surface, which were naturally formed from a sputtered gold layer. The growth process of nanostructures was carried out at atmospheric pressure, at 90 °C for 10 seconds. As a result of this process, gold balls nucleate a uniform growth of the CuO layer. The result of the process was a 100 nm thick CuO layer on the surface of the silicon substrate.

In the second example, a 1 mm quartz plate was used as the substrate. In the first step of this method, a thin (approx. 3 nm) silver layer was sprayed onto the surface of this substrate by cathodic sputtering. In the second step of this method, a reaction mixture with a pH of 9 was prepared. For this purpose, 1.5 g of copper acetate was dissolved in 150 ml of distilled water (which acts as a solvent and oxygen precursor). The appropriate pH of the mixture was obtained after thorough mixing by precipitation of a metal hydroxide which is sodium hydroxide. In the mixture prepared in this way, the previously prepared substrate was placed, on the surface of which were silver nanostructures formed naturally from a sputtered layer. The nanostructures growth process was carried out at atmospheric pressure, at 95 °C for 5 seconds.

As a result of this process, silver balls nucleate a uniform growth of the CuO layer. The result of the process was a 10 nm thick CuO layer on the surface of a quartz substrate.

In the third example, a 0.5 mm thick silicon wafer was used as the substrate. A thin (2 nm) copper layer was sprayed on the surface of this substrate by cathodic sputtering. In a second step of this method, a reaction mixture with a pH of 7.5 was prepared. For this purpose, 3 g of copper acetate was dissolved in 150 ml of distilled water (which acts as a solvent and oxygen precursor). The appropriate pH of the mixture was obtained after thorough mixing by precipitation of a metal hydroxide which is sodium hydroxide. The previously prepared substrate with a layer of copper on the surface was placed in the mixture prepared in this way. The growth process of nanostructures was carried out at atmospheric pressure, at 90 °C for 20 seconds. As a result of this process, copper on the substrate nucleates a uniform growth of the CuO layer. The result of the process was a 100 nm thick CuO layer on the surface of the substrate.

The obtained layers are permanently attached to the substrate and can be used for practical applications of sensor, photovoltaic or emission type. The method according to the invention does not require the use of a high vacuum, it can be carried out on large substrates, it is fast and simple, which makes it a cheap, efficient and well suited for industrial scale applications.

## Claims

1. A hydrothermal method for preparing a CuO layer on a substrate, **characterized in that** in the first step a nucleation layer is prepared on the substrate, wherein the nucleation layer is prepared by spraying a metal layer or by depositingemetal nanoparticles from a solution, and in the second step a reaction mixture with a pH value of 6.5 to 9 is prepared, consisting of a solvent, water as an oxygen precursor, at least one copper precursor and sodium hydroxide, and the substrate containing the nucleation layer is placed in this mixture, then the mixture is heated to 60-100 °C, and the CuO layer is grown for at least 1 second, wherein the growth nucleation layer is a metal layer, at least 0.1 nm thick.

2. The method according to claim 1, **characterized in that** the growth nucleation layer is of metallic nanostructures.

3. The method according to claim 1, **characterized in that** the copper precursor is copper acetate.

4. The method according to claim 1, **characterized in that** the copper precursor is copper nitrate.

5. The method according to claim 1, **characterized in that** the substrate is a semiconductor or glass substrate.

6. The method according to claim 1 or 2, **characterized in that** the nucleation layer is a metal layer of Au, Ag or Cu.

7. The method according to claim 1, 2, 3 or 6, **characterized in that** the nucleation layer is of metallic nanostructures of Au, Ag or Cu in an amount greater than 100 nanostructures on an area of 1 µm².

## Patentansprüche

1. Hydrothermales Verfahren zur Herstellung einer CuO-Schicht auf einem Substrat, **dadurch gekennzeichnet, dass** im ersten Schritt eine Keimschicht auf dem Substrat hergestellt wird, wobei die Keimschicht durch Aufsprühen einer Metallschicht oder durch Abscheidung von Metallnanopartikeln aus einer Lösung hergestellt wird, und im zweiten Schritt ein Reaktionsgemisch mit einem pH-Wert von 6,5 bis 9 hergestellt wird, bestehend aus einem Lösungsmittel, Wasser als Sauerstoffvorläufer, mindestens einem Kupfervorläufer und Natriumhydroxid, und das Substrat, das die Keimschicht enthält, in dieses Gemisch eingebracht wird, dann das Gemisch auf 60-100 °C erhitzt wird, und die CuO-Schicht mindestens 1 Sekunde lang ausgebildet wird, wobei die Wachstumskeimschicht eine Metallschicht ist, die mindestens 0,1 nm dick ist.

2. Verfahren nach Anspruch 1, **dadurch gekennzeichnet, dass** die Wachstumskeimschicht aus metallischen Nanostrukturen besteht.

3. Verfahren nach Anspruch 1, **dadurch gekennzeichnet, dass** der Kupfervorläufer Kupferacetat ist.

4. Verfahren nach Anspruch 1, **dadurch gekennzeichnet, dass** der Kupfervorläufer Kupfernitrat ist.

5. Verfahren nach Anspruch 1, **dadurch gekennzeichnet, dass** das Substrat ein Halbleitersubstrat oder Glassubstrat ist.

6. Verfahren nach Anspruch 1 oder 2, **dadurch gekennzeichnet, dass** die Keimschicht eine Metallschicht aus Au, Ag oder Cu ist.

7. Verfahren nach Anspruch 1, 2, 3 oder 6, **dadurch gekennzeichnet, dass** die Keimschicht aus metallischen Nanostrukturen aus Au, Ag oder Cu in einer Menge von mehr als 100 Nanostrukturen auf einer Fläche von 1 µm² besteht.

## Revendications

1. Procédé hydrothermal de préparation d'une couche de CuO sur un substrat, **caractérisé en ce que** lors de la première étape une couche de nucléation est préparée sur le substrat, dans lequel la couche de nucléation est préparée par pulvérisation d'une couche métallique ou par dépôt de nanoparticules métalliques à partir d'une solution, et lors de la deuxième étape un mélange réactionnel présentant une valeur de pH de 6,5 à 9 est préparé, consistant en un solvant, de l'eau en tant que précurseur d'oxygène, au moins un précurseur de cuivre et de l'hydroxyde de sodium, et le substrat contenant la couche de nucléation est placé dans ce mélange, puis le mélange est chauffé à 60-100 °C, et la couche de CuO est faite croître pendant au moins 1 seconde, dans lequel procédé la couche de nucléation de croissance est une couche métallique, d'une épaisseur d'au moins 0,1 nm.

2. Procédé selon la revendication 1, **caractérisé en ce que** la couche de nucléation de croissance est constituée de nanostructures métalliques.

3. Procédé selon la revendication 1, **caractérisé en ce que** le précurseur de cuivre est l'acétate de cuivre.

4. Procédé selon la revendication 1, **caractérisé en ce que** le précurseur de cuivre est le nitrate de cuivre.

5. Procédé selon la revendication 1, **caractérisé en ce que** le substrat est un substrat semi-conducteur ou un substrat en verre.

6. Procédé selon la revendication 1 ou la revendication 2, **caractérisé en ce que** la couche de nucléation est une couche métallique d'Au, d'Ag ou de Cu.

7. Procédé selon la revendication 1, la revendication 2, la revendication 3 ou la revendication 6, **caractérisé en ce que** la couche de nucléation est constituée de nanostructures métalliques d'Au, d'Ag ou de Cu en une quantité supérieure à 100 nanostructures sur une surface de 1 µm².
